# EUROPÄISCHE PATENTSCHRIFT

(11) **EP 1 806 848 B1**
(45) Veröffentlichungstag und Bekanntmachung des Hinweises auf die Patenterteilung: **25.03.2009**
(21) Anmeldenummer: 06025266.5
(22) Anmeldetag: 07.12.2006
(51) Int. Cl.: H03L 3/00, H03L 7/10

(54) **Phasenregelkreis**
Phase-locked loop
Boucle à verrouillage de phase

(30) Priorität: 04.01.2006 DE 102006000735; 02.03.2006 DE 102006009644
(43) Veröffentlichungstag der Anmeldung: 11.07.2007
(73) Patentinhaber: BIOTRONIK CRM Patent AG, 6341 Baar (CH)
(72) Erfinder: Garzarolli, Matthias, 91056 Erlangen (DE); Lang, Martin, Dr., 91085 Weisendorf (DE)
(74) Vertreter: Lindner-Vogt, Karin L.

(56) Entgegenhaltungen:
- EP-A- 0 664 616
- EP-A1- 0 652 642
- US-A1- 4 896 122
- US-A1- 6 121 849

## Beschreibung

Die Erfindung betrifft einen Phasenregelkreis (PLL) zur Frequenzsynthese mit verbessertem Startverhalten. Ein Phasenregelkreis zur Frequenzsynthese besitzt einen Phasen- oder Phasenfrequenzdetektor, einen regelbaren Oszillator, ein Schleifenfilter und einen Frequenzteiler. Um ein Referenztaktsignal für die Frequenzsynthese zur Verfügung zu stellen, besitzt der Phasenregelkreis einen Referenzoszillator oder ist mit einem solchen verbunden. Der Referenzoszillator oder der Referenzoszillator und ein hinter diesen geschalteter Referenztaktteiler erzeugen ein Referenztaktsignal und geben dieses an einen Referenzeingang des Phasen- oder Phasenfrequenzdetektors aus. Der regelbare Oszillator ist vorgesehen, um ein Taktsignal mit einer einstellbaren Synthesefrequenz zu erzeugen und auszugeben. Die Synthesefrequenz ist dabei durch ein an den Steuereingang des regelbaren Oszillators anzulegendes Steuersignal einstellbar. Das Steuersignal wird im Betrieb durch den Regelmechanismus des Phasenregelkreises so eingestellt, dass der regelbare Oszillator ein Taktsignal mit genau der gewünschten Synthesefrequenz erzeugt.

Der Frequenzteiler ist mit dem regelbaren Oszillator verbunden und ausgebildet, das vom regelbaren Oszillator ausgegebene Taktsignal durch einen Teilerwert zu teilen und so ein Teilertaktsignal mit einer niedrigeren Frequenz als der Synthesefrequenz zu erzeugen. Diese niedrigere Frequenz des Teilertaktsignals entspricht der Synthesefrequenz geteilt durch den Teilerwert. Das Teilertaktsignal wird auf einen Rückkoppeleingang des Phasen-oder Phasenfrequenzdetektors rückgekoppelt, der das Referenztaktsignal und das Teilertaktsignal miteinander vergleicht und an das Schleifenfilter ein Vergleichsignal ausgibt, das eine Information über den Phasenbezug und/oder den Frequenzbezug von Referenz- und Teilertaktsignal enthält.

Das Schleifenfilter erzeugt durch Filtern des vom Phasen- oder Phasenfrequenzdetektor ausgegebenen Vergleichssignals ein Steuersignal für den regelbaren Oszillator.

Phasenregelkreise sind ein im Stand der Technik weit bekanntes Mittel zur Erzeugung von elektrischen Signalen einer gewünschten Synthesefrequenz. Dabei wird das erzeugte Taktsignal fortlaufend mit einem Referenztaktsignal einer festen Referenzfrequenz verglichen, wobei das Referenztaktsignal gewöhnlich von einem Quarzoszillator erzeugt wird und von besonderer Präzision ist. Durch die Regelwirkung des Phasenregelkreises wird das synthetisierte Taktsignal an das Referenztaktsignal gekoppelt, so dass im eingerasteten Zustand des Phasenregelkreises ein fester Bezug zwischen den Frequenzen des synthetisierten Taktsignals und des Referenztaktsignals besteht. Dieser feste Bezug wird durch den im Rückkoppelpfad des Phasenregelkreises befindlichen Frequenzteiler vorgegeben. Ein Frequenzteiler ist gewöhnlich ein digitaler Zähler, der durch das synthetisierte Taktsignal getaktet wird und zyklisch bis zu einem vorgegebenen oder einstellbaren Teilerwert zählt. Bei Erreichen des Teilerwertes bzw. des halben Teilerwertes invertiert der Frequenzteiler den logischen Pegel an seinem Ausgang, wodurch er ein Teilertaktsignal mit einer gegenüber der Synthesefrequenz um den Teilerwert heruntergeteilten Frequenz erzeugt.

Da die Regelwirkung des Phasenregelkreises sicherstellt, dass die Frequenzen des Teilertaktsignals und des Referenztaktsignals wenigstens näherungsweise gleich sind, wird der regelbare Oszillator des Phasenregelkreises im Betrieb so eingestellt, dass die Synthesefrequenz des synthetisierten Taktsignals um den Teilerwert des Frequenzteilers höher ist als die Frequenz des Referenztaktsignals. Durch Vorgabe verschiedener Teilerwerte können bei gleichbleibender Frequenz des Referenztaktsignals somit Taktsignale verschiedener Synthesefrequenzen erzeugt werden.

EP 0 652 642 A1 weist einen primären Phasenregelkreis auf, der einen sekundären Phasenregelkreis zur Taktsynchronisation auf eine externe Referenzfrequenz festlegt. So wird der Referenzoszillator zur Konstanthaltung der Frequenz kontrolliert. Bei Ausfall der Referenzfrequenz agiert der sekundäre Phasenregelkreis als Referenz.

Ein wichtiges Einsatzgebiet von Phasenregelkreisen zur Frequenzsynthese liegt in der Synthese von Taktsignalen für das Senden oder Empfangen von Funksignalen. In einigen Anwendungen, vor allem zur periodischen oder durch ein Ereignis ausgelösten Funkübertragung von Messwerten oder zur Überwachung eines Funkkanals auf Aktivität eines Kommunikationspartners, ist der Energieverbrauch pro Aktivierung des Sende- und Empfangsschaltkreises mitsamt des Phasenregelkreises von großem Einfluss auf die mögliche Betriebs- oder Lebensdauer der Vorrichtung. Dies gilt insbesondere für medizinische Implantate, die über mehrere Jahre im Körper therapeutische Funktionen erfüllen müssen und nur einen kleinen Bruchteil der Batteriekapazität zu Kommunikationszwecken erübrigen können.

Wegen der in diesen Anwendungen geringen zu übertragenden Datenmenge oder notwendigen Überwachungsdauer ist die Aktivierungsdauer typischerweise so kurz, dass die Anlaufzeit der Frequenzsynthese und der damit verbundene Energieverbrauch nicht mehr vernachlässigbar sind. Da im Referenzoszillator Resonanzelemente hoher Güte, z. B. Kristallquarze, verwendet werden, um eine hohe Frequenzstabilität und geringes Seitenbandrauschen zu erzielen, fällt die Anlaufzeit des Referenzoszillators besonders ins Gewicht. Ohne besondere Maßnahmen liegt diese bei den typischen Frequenzen der Funkkommunikation bei etwa 1 bis 10 ms, während der Phasenregelkreis selbst Einschwingzeiten von nur etwa 10 bis 100 µs benötigt und die eigentliche Kommunikations- oder Überwachungsdauer in der Größenordnung der Anlaufzeit des Referenzoszillators oder sogar darunter liegen kann.

Im Stand der Technik sind zwei Lösungen bekannt, um die Anlaufzeit des Referenzoszillators zu verkürzen. Bei der ersten wird ein starkes Impulssignal an einen Anschluss des Referenzoszillators gelegt, das diesen aus dem Gleichgewichtszustand bringen soll, bei der zweiten wird die Verstärkung des dem Resonator des Referenzoszillators antiparallel geschalteten invertierenden Verstärkers über das für den Betrieb im eingeschwungenen Zustand notwendige Maß erhöht, um das immer vorhandene Rauschen stark zu verstärken und den Referenzoszillator durch das verstärkte Rauschsignal aus dem Gleichgewichtszustand zu bringen.

Problematisch ist jedoch, dass beide Maßnahmen frequenzunspezifisch sind und deswegen eine nicht vorher bestimmbare Beschleunigung des Einschwingens des Referenzoszillators bewirken, weshalb die Anlaufzeit des Referenzoszillators weiterhin nicht genau vorhersagbar ist.

Der Erfindung liegt die Aufgabe zugrunde, einen Phasenregelkreis zu schaffen, der insbesondere hinsichtlich der Anlaufzeit des Referenzoszillators gegenüber dem Stand der Technik verbessert ist.

Erfindungsgemäß wird diese Aufgabe durch einen Phasenregelkreis gelöst, der über einen Speicher für einen Steuerwert verfügt, der über einen abhängig von einem ersten Schaltsignal schaltbaren ersten Schalter mit dem Steuereingang des regelbaren Oszillators zu verbinden ist. Außerdem weist der Phasenregelkreis einen zweiten Schalter auf, über den der Frequenzteiler ausgangsseitig abhängig von einem zweiten Schaltsignal mit dem Referenzoszillator verbindbar ist. Indem bei Inbetriebnahme des erfindungsgemäßen Phasenregelkreises oder zu einem anderen fest vorgegebenen oder wählbaren Initialisierungszeitpunkt der erste und der zweite Schalter geschlossen werden, wird der Speicher für den Steuerwert mit dem Steuereingang des regelbaren Oszillators verbunden und gibt den gespeicherten Steuerwert an den regelbaren Oszillator aus, wodurch dieser nach einer für regelbare Oszillatoren typischen kurzen Einschwingzeit ein Taktsignal erzeugt und ausgibt, das bereits eine Frequenz nahe der gewünschten Synthesefrequenz besitzt. Der Frequenzteiler teilt dieses Taktsignal herunter und erzeugt somit ein Teilertaktsignal, das eine Frequenz besitzt, die in der Nähe der Resonanzfrequenz des Resonators des Referenzoszillators liegt. Das Teilertaktsignal gelangt über den geschlossenen zweiten Schalter an den Referenzoszillator, der aufgrund der Anregung durch ein Signal mit einer Frequenz nahe seiner Resonanzfrequenz nun sehr schnell anläuft. Nach einer kurzen Einschwingzeitspanne können der erste und der zweite Schalter geöffnet werden, woraufhin der Phasenregelkreis gemäß seiner Regelfunktion auf das Referenztaktsignal einrastet und der regelbare Oszillator durch das nun vorhandene Referenztaktsignal exakt auf die gewünschte Synthesefrequenz eingestellt wird.

Um eine Unabhängigkeit der Resonanzfrequenz des Referenzoszillators von der Regelfrequenz des Phasenregelkreises zu erreichen, ist bei einer Ausführungsform der Erfindung ein dem Referenzoszillator nachgeschalteter Referenztaktteiler vorgesehen, der ausgebildet ist, das Referenztaktsignal durch Teilen durch den Referenzteilerwert zu erzeugen und an den Phasen-oder Phasenfrequenzdetektor auszugeben.

Der im Speicher gespeicherte Steuerwert kann fest vorgegeben oder durch eine Messung während einer vorhergehenden Inbetriebnahme bestimmt worden sein. Eine solche Messung kann dabei nicht nur einmalig, sondern auch mehrfach, beispielsweise periodisch oder zu wählbaren Zeitpunkten, durchgeführt werden. Im Fall sowohl eines fest vorgegebenen gespeicherten wie auch eines durch eine Messung bestimmten Steuerwertes kann der Phasenregelkreis einen Speicher für einen digitalen Steuerwert und einen Digital/Analog-Umsetzer aufweisen, wobei der Speicher den gespeicherten digitalen Steuerwert an den Digital/Analog-Umsetzer ausgibt, der den digitalen Steuerwert in einen analogen Steuerwert für den regelbaren Oszillator umsetzt.

Für den Fall des Bestimmens des gespeicherten Steuerwertes durch eine Messung kann der Phasenregelkreis zusätzlich über einen Analog/Digital-Umsetzer verfügen, der eingangsseitig mit dem Steuereingang des regelbaren Oszillators verbunden oder verbindbar ist und der ausgangsseitig mit dem Speicher verbunden ist. Der Analog/Digital-Umsetzer ist dabei ausgebildet, einen am Steuereingang des regelbaren Oszillators anliegenden Steuerwert in einen digitalen Steuerwert umzusetzen und zum Speichern an den Speicher auszugeben.

Alternativ kann der Speicher als Sample-and-Hold-Glied (dt.: Abtasthalteglied) ausgebildet sein, einen am Steuereingang des regelbaren Oszillators anliegenden Steuerwert abzutasten, zu speichern und bei Bedarf an den Steuereingang des regelbaren Oszillators auszugeben. Da bei einem Sample-and-Hold-Glied der an dessen Eingang anliegende Spannungswert kapazitiv gespeichert wird und während der Dauer des Speicherns Störeinflüssen wie Rauschen und Tunnelströmen unterworfen ist, eignet sich diese Ausführungsvariante der Erfindung besonders für Systeme, bei denen der Steuerwert für den regelbaren Oszillator über kurze Zeitspannen gespeichert werden soll. Die besonderen Vorteile dieser Ausführungsvariante liegen in dem besonders geringen Schaltungsaufwand für die Implementierung des Speichers und dem Wegfall eines Quantisierungsfehlers bei einer Analog/Digital-Umsetzung.

Der erfindungsgemäße Phasenregelkreis kann auch mehr als einen Speicher aufweisen. Um die Vorteile des Speichers für einen digitalen Steuerwert und des Sample-and-Hold-Gliedes zu vereinen, weist eine weitere Ausführungsvariante des erfindungsgemäßen Phasenregelkreises zwei Speicher auf, von denen ein erster Speicher als Speicher für einen digitalen Steuerwert und ein zweiter Speicher als Sample-and-Hold-Glied ausgebildet sind.

Um den Regelmechanismus des Phasenregelkreises während der Anlaufzeit des Referenzoszillators vollständig zu deaktivieren und somit eine Störung des beschleunigten Einschwingens des Referenzoszillators zu verhindern, kann bei einer besonders bevorzugten Ausführung des Phasenregelkreises der Regelkreis zwischen dem Phasen- oder Phasenfrequenzdetektor und dem regelbaren Oszillator aufgetrennt werden. Hierfür wird ein abhängig von einem dritten Schaltsignal schaltbarer dritter Schalter zwischen Phasen- oder Phasenfrequenzdetektor und regelbaren Oszillator geschaltet, der während des Einschwingens des Referenzoszillators geöffnet und im normalen Betrieb des Phasenregelkreises geschlossen werden kann.

Zur Koordinierung der Vorgänge im Phasenregelkreis bei Inbetriebnahme weist eine bevorzugte Ausführung des erfindungsgemäßen Phasenregelkreises eine Steuereinheit auf, die ausgebildet ist, auf ein Initialisierungssignal hin den ersten und den zweiten Schalter durch Ausgeben eines entsprechenden ersten bzw. zweiten Schaltsignals zu veranlassen, sich zu schließen.

Bei einer Ausführung des Phasenregelkreises mit einem dritten Schalter kann die Steuereinheit außerdem ausgebildet sein, auf das Initialisierungssignal hin ein drittes Schaltsignal auszugeben, das den dritten Schalter dazu veranlasst, sich zu öffnen.

Die Ausführungsvarianten des Phasenregelkreises mit einer Steuereinheit können zusätzlich über einen Referenztaktdetektor verfügen, der mit dem Referenzoszillator verbunden und ausgebildet ist, das Vorhandensein eines gültigen Referenztaktsignals zu detektieren und der Steuereinheit durch ein PLL-Startsignal zu signalisieren. Ein gültiges Referenztaktsignal kann beispielsweise dann vorliegen, wenn das Referenztaktsignal einen bestimmten minimalen Signalhub (Swing) oder eine bestimmte Frequenzstabilität aufweist. Der Referenztaktdetektor kann beispielsweise durch einen Zähler gebildet werden, dessen Takteingang mit dem Referenzoszillator verbunden ist, so dass der Referenztaktdetektor erst bei Vorliegen eines Referenztaktes zu zählen beginnt. Um eine Sicherheitszeitspanne abzuwarten, bis der Referenzoszillator einen frequenzstabilen Referenztakt ausgibt, kann der Referenztaktdetektor ausgebildet sein, erst bei Erreichen eines vorgebbaren Zählerstandes das PLL-Startsignal auszugeben.

In einer Fortführung dieser Ausführungsvariante ist die Steuereinheit ausgebildet, auf den Erhalt des PLL-Startsignals hin ein erstes und ein zweites Schaltsignal auszugeben, die den ersten bzw. zweiten Schalter veranlassen, sich zu öffnen. Dadurch wird die Anlaufphase des Referenzoszillators bzw. des erfindungsgemäßen Phasenregelkreises beendet und der Phasenregelkreis nimmt seinen Betrieb auf. Besitzt der Phasenregelkreis einen dritten Schalter, kann die Steuereinheit ausgebildet sein, auf den Erhalt des PLL-Startsignals hin ein drittes Schaltsignal auszugeben, das den dritten Schalter veranlasst, sich zu schließen.

Für den Fall, dass die Betriebsparameter des Phasenregelkreises starken Schwankungen unterworfen sind und daher die tatsächliche Synthesefrequenz des vom regelbaren Oszillators für denselben gespeicherten Steuerwert erzeugten Signals stark variieren kann, ist bei einer besonders bevorzugten Ausführungsvariante des erfindungsgemäßen Phasenregelkreises ein Speicher vorgesehen, der ausgebildet ist, eine Reihe von verschiedenen Steuerwerten auszugeben, wobei die Reihe wenigstens zwei voneinander verschiedene Steuerwerte umfasst, so dass, je nach Ausgabereihenfolge der verschiedenen Steuerwerte, der regelbare Oszillator veranlasst wird, ein Taktsignal mit einer einen Frequenzbereich aufsteigend, absteigend oder mit wechselndem Richtungssinn überstreichenden Synthesefrequenz zu erzeugen. Auf diese Weise kann bei geeigneter Wahl der Reihe der Steuerwerte sichergestellt werden, dass die Frequenz des durch den Frequenzteiler heruntergeteilten Teilertaktsignals wenigstens zeitweilig gleich der Resonanzfrequenz des Referenzoszillators ist, wodurch dieser in jedem Fall zu einer Resonanz und damit zu einem beschleunigten Anlaufen bewegt wird.

Ein zweiter Aspekt der Erfindung betrifft ein elektromedizinisches Implantat, wie beispielsweise einen Herzschrittmacher, Defibrillator oder Kardioverter mit einer Telemetrieeinheit für die Übertragung von Daten vom Implantat an ein externes Gerät, bei dem die Telemetrieeinheit für die Erzeugung eines Sende-oder Empfangstaktes einen Phasenregelkreis gemäß dem ersten Aspekt der Erfindung umfasst. Die kurze Anlaufzeit des erfindungsgemäßen Phasenregelkreises ermöglicht es, den Phasenregelkreis in kurzen Abständen zu aktivieren und zu deaktivieren und dadurch Energie zu sparen, die besonders in elektromedizinischen Implantaten nur stark begrenzt zur Verfügung steht.

Im Folgenden wird die Erfindung anhand von Abbildungen von Ausführungsbeispielen näher beschrieben. Es zeigen:
- Figur 1:: eine allgemeine Darstellung eines erfindungsgemäßen Phasenregelkreises in Form eines Blockschaltbildes;
- Figur 2:: eine Ausführungsvariante eines erfindungsgemäßen Phasenregelkreises mit einem dritten Schalter, zwei Speichern, einem Analog/Digital-Umsetzer, einer Steuereinheit und einem Referenztaktdetektor; und
- Figur 3:: eine etwas konkretere und erweiterte Darstellung des erfindungsgemäßen Phasenregelkreises gemäß Figur 1.

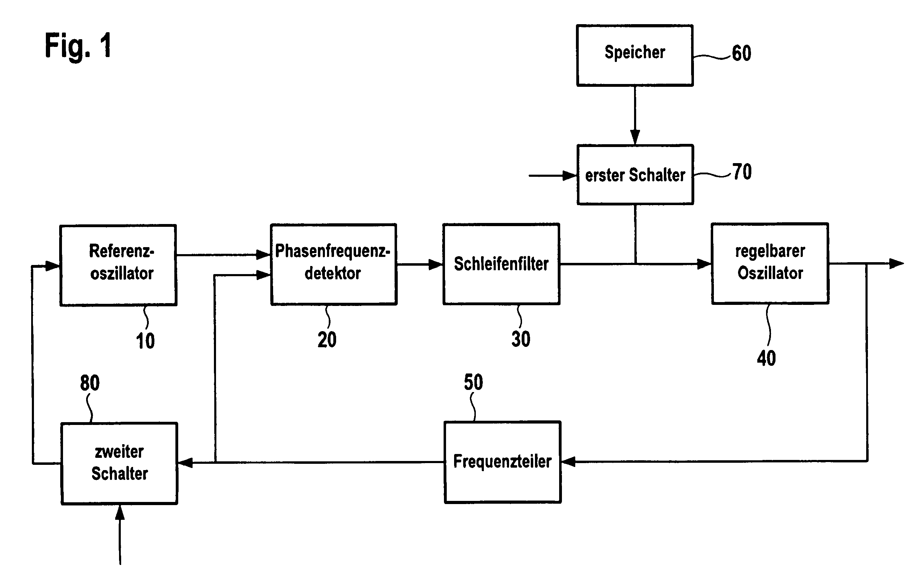

Der in Figur 1 gezeigte Phasenregelkreis zur Frequenzsynthese umfasst einen Referenzoszillator 10, der ausgangsseitig mit einem Phasenfrequenzdetektor 20 verbunden ist. Anstelle des Phasenfrequenzdetektors 20 könnte auch ein Phasendetektor oder in speziellen Ausführungen ein Frequenzdetektor Verwendung finden. Der eigentliche Regelkreis des Phasenregelkreises umfasst außer dem Phasenfrequenzdetektor 20 ein dem Phasenfrequenzdetektor 20 nachgeschaltetes Schleifenfilter 30, einen regelbaren Oszillator 40, der das vom Phasenregelkreis zu synthetisierende Taktsignal erzeugt, sowie einen Frequenzteiler 50, der das Taktsignal durch einen Teilerwert teilt und auf einen Rückkoppeleingang des Phasenfrequenzdetektors 20 rückkoppelt. Erfindungsgemäß ist der Phasenregelkreis durch einen ersten Schalter 70, einen Speicher 60 und einen zweiten Schalter 80 erweitert. Der Speicher 60 ist ausgebildet, einen Steuerwert für den regelbaren Oszillator 40 zu speichern und über den ersten Schalter 70, wenn dieser geschlossen ist, an den steuerbaren Eingang des regelbaren Oszillators 40 auszugeben. Der erste Schalter 70 ist vorgesehen, um den Speicher 60 abhängig von einem ersten Schaltsignal mit dem Steuereingang des regelbaren Oszillators zu verbinden oder ihn von diesem abzutrennen. Der zweite Schalter 80 verbindet abhängig von einem zweiten Schaltsignal den Ausgang des Frequenzteilers 50 mit dem Referenzoszillator 10.

Bei Inbetriebnahme des erfindungsgemäßen Phasenregelkreises sind der erste Schalter 70 und der zweite Schalter 80 geschlossen, so dass der Ausgang des Speichers 60 mit dem Steuereingang des regelbaren Oszillators 40 und der Ausgang des Frequenzteilers 50 mit dem Referenzoszillator 10 verbunden sind. Der in dem Speicher 60 gespeicherte Steuerwert für den regelbaren Oszillator 40 repräsentiert einen typischen Steuerwert für den regelbaren Oszillator 40, der den regelbaren Oszillator 40 dazu veranlasst, ein Taktsignal einer Frequenz nahe der gewünschten Synthesefrequenz zu erzeugen. Da der regelbare Oszillator 40 schneller anläuft als der Referenzoszillator 10, steht in dieser Phase kein Referenztaktsignal zur Verfügung, so dass der Regelmechanismus des Phasenregelkreises noch nicht wirken und den regelbaren Oszillator 40 so aussteuern kann, dass bereits exakt die gewünschte Synthesefrequenz eingestellt wird. Das während der Anlaufphase vom regelbaren Oszillator 40 erzeugte Taktsignal wird vom Frequenzteiler 50 durch den Teilerwert heruntergeteilt, wodurch ein Rückkoppeltaktsignal entsteht, dessen Frequenz in der Nähe der Resonanzfrequenz des Referenzoszillators 10 liegt. Das Rückkoppeltaktsignal gelangt über den während der Anlaufphase geschlossenen zweiten Schalter 80 an den Referenzoszillator 10 und regt diesen aufgrund der großen Nähe zu der Resonanzfrequenz des Referenzoszillators 10 innerhalb von kurzer Zeit zum Schwingen an, wodurch die Anlaufzeit des Referenzoszillators 10 und somit des erfindungsgemäßen Phasenregelkreises deutlich verkürzt wird.

Sobald der Referenzoszillator 10 eingeschwungen ist, kann der Phasenregelkreis den vorgesehenen Regelmechanismus ausüben und den regelbaren Oszillator 40 so aussteuern, dass die Frequenz des Rückkoppeltaktsignales und des Referenztaktsignales an den Eingängen des Phasenfrequenzdetektors gleich sind. Wenn diese Bedingung erfüllt ist, ist die Frequenz des vom regelbaren Oszillator 40 erzeugten Taktsignales gleich der gewünschten Synthesefrequenz. Um den Regelmechanismus des Phasenregelkreises zu aktivieren, müssen der erste Schalter 70 und der zweite Schalter 80 geöffnet werden, damit der Steuerwert am Steuereingang des regelbaren Oszillators 40 durch das vom Schleifenfilter 30 gefilterte und vom Phasenfrequenzdetektor 20 erzeugte Vergleichssignal ausgesteuert werden kann und der Referenzoszillator 10 nicht mehr durch das vom Frequenzteiler 50 über den zweiten Schalter 80 eingekoppelte Referenztaktsignal beeinflusst wird.

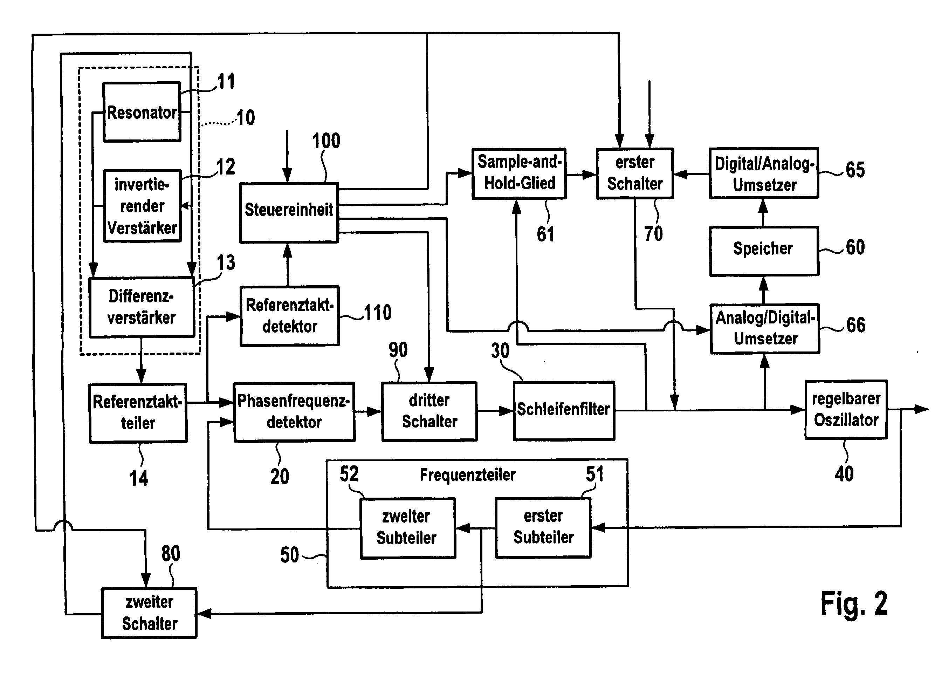

Die in Figur 2 gezeigte bevorzugte Ausführungsvariante des erfindungsgemäßen Phasenregelkreises wurde gegenüber dem in Figur 1 abgebildeten Phasenregelkreis um einige Komponenten erweitert. In den eigentlichen Phasenregelkreis wurde zwischen dem Phasenfrequenzdetektor 20 und dem Schleifenfilter 30 ein dritter Schalter 90 eingefügt, durch den abhängig von einem dritten Schaltsignal der Ausgang des Schleifenfilters 30 vom Eingang des regelbaren Oszillator 40 abgetrennt werden kann. Der dritte Schalter 90 ist mit einer Steuereinheit 100 verbunden, die außer dem dritten Schaltsignal für den dritten Schalter 90 das erste Schaltsignal für den ersten Schalter 70 und das zweite Schaltsignal für den zweiten Schalter 80 erzeugt. In dem abgebildeten Ausführungsbeispiel werden der erste Schalter 70 und der zweite Schalter 80 immer gemeinsam in denselben jeweiligen Zustand geschaltet, so dass das erste und das zweite Schaltsignal identisch sind und der erste Schalter 70 und der zweite Schalter 80 mit demselben Ausgang der Steuereinheit 100 verbunden sind.

Der Referenzoszillator 10 ist in Figur 2 in seine Hauptkomponenten zergliedert dargestellt. Diese sind ein Resonator 11, ein invertierender Verstärker 12 und ein Differenzverstärker 13. Der invertierende Verstärker 12 ist antiparallel mit dem Resonator 11 verschaltet und regt diesen im eingeschwungenen Zustand zum Schwingen an, indem er die Verstärkung des Kreises aus Resonator 11 und invertierendem Verstärker 12 an der Resonanzfrequenz des Resonators 11 größer 1 einstellt. Die beiden Pole des Resonators 11 sind mit den Differenzeingängen des Differenzverstärkers 13 verbunden, der das vom Resonator 11 und dem invertierenden Verstärker 12 erzeugte Taktsignal verstärkt und single-ended an einen Referenztaktteiler 14 ausgibt, der es durch einen Referenztaktteilerwert herunterteilt, also die Frequenz des vom Differenzverstärker 13 ausgegebenen Taktsignals durch den Referenztaktteilerwert herunterteilt. Eine solche Anordnung bietet die größtmögliche Freiheit bei der Wahl der Taktfrequenzen von Referenzoszillator und der Eckfrequenz der Regelfunktion des Phasenregelkreises, wobei diese Anordnung einen zweistufigen Frequenzteiler 50 mit einem ersten Subteiler 51 und einem zweiten Subteiler 52 bedingt, damit sowohl die Frequenzen der Signale an den beiden Eingängen des Phasenfrequenzdetektors 20 im eingerasteten Zustand des Phasenregelkreises, als auch des vom Frequenzteiler 50 hinter dem ersten Subteiler 51 abgezweigten Rückkoppeltaktsignals und der Resonanzfrequenz des Referenzoszillators 10 gleich sind. Die Teilerwerte des zweiten Subteilers 52 und des Referenztaktteilers 14 sind in einer solchen Anordnung gewöhnlich gleich zu wählen, der Gesamtteilerwert des Frequenzteilers 50 ergibt sich aus dem Produkt der Teilerwerte von erstem und zweitem Subteiler 51/52.

Der Referenztaktteiler 14 ist ausgangsseitig mit dem Referenzeingang des Phasenfrequenzdetektors 20 verbunden, an den er das heruntergeteilte Referenztaktsignal ausgibt. Der Ausgang des Differenzverstärkers 13 ist außerdem mit einem Referenztaktdetektor 110 verbunden, der die Aufgabe hat, das Vorhandensein eines gültigen Referenztaktes zu detektieren und der mit dem Referenztaktdetektor 110 verbundenen Steuereinheit 100 zu signalisieren, damit diese den ersten Schalter 70 und den zweiten Schalter 80 dazu veranlassen kann, sich zu öffnen und den dritten Schalter 90 dazu, sich zu schließen, wodurch die Anlaufphase des erfindungsgemäßen Phasenregelkreises abgeschlossen ist und der Regelmechanismus des Phasenregelkreises zu wirken beginnen kann. Die Steuereinheit 100 besitzt außerdem einen Eingang für ein Initialisierungssignal, auf dessen Erhalt hin die Steuereinheit 100 die Anlaufphase durch Ausgabe von entsprechenden ersten, zweiten und dritten Schaltsignalen an den ersten, zweiten bzw. dritten Schalter (70, 80, 90) einleitet.

Während der Anlaufphase sind das Schleifenfilter 30 und somit der Steuereingang des regelbaren Oszillators 40 vom Ausgang des Phasenfrequenzdetektors 20 aufgrund des geöffneten dritten Schalters 90 abgetrennt, so dass in Abwesenheit eines Referenztaktsignales kein ungültiger Steuerwert für den regelbaren Oszillator 40 erzeugt wird. Um dennoch einen gültigen Steuerwert für den regelbaren Oszillator 40 an dessen Steuereingang anzulegen, wird der Ausgang entweder eines Sample-and-Hold-Gliedes 61 oder eines mit einem Speicher 60 verbundenen Digital/Analog-Umsetzers 65 über den ersten Schalter 70 mit dem Steuereingang des regelbaren Oszillators 40 verbunden. Welche der beiden Komponenten dabei durch den ersten Schalter 70 mit dem Steuereingang des regelbaren Oszillators 40 verbunden werden sollen, kann durch ein weiteres Schaltsignal für den ersten Schalter 70 vorgegeben werden. Das Sample-and-Hold-Glied 61 ist eingangsseitig mit dem Steuereingang des regelbaren Oszillators 40 verbunden und ausgebildet, einen dort anliegenden Steuerwert zu einem wählbaren Zeitpunkt kapazitiv zu speichern. Der Speicher 60 ist ausgebildet, einen in eine digitale Repräsentation überführten Steuerwert zu speichern und an den Digital/Analog-Umsetzer 65 für die Umsetzung in einen analogen Steuerwert für den regelbaren Oszillator 40 auszugeben. Der Speicher 60 ist im abgebildeten Ausführungsbeispiel durch einen Analog/Digital-Umsetzer 66 beschreibbar ausgebildet, um sicherzustellen, dass der vom Speicher 60 gespeicherte, von zahlreichen Betriebsparametern abhängige Steuerwert einen für den jeweiligen Phasenregelkreis geeigneten, an die herrschenden Betriebsbedingungen angepassten Steuerwert enthält. Der Analog/Digital-Umsetzer 66 kann dazu zu einem wählbaren Zeitpunkt den am regelbaren Oszillator 40 anliegenden Steuerwert in eine digitale Repräsentation umsetzen und an den Speicher 60 ausgeben. Ebenfalls ist es vorstellbar, periodisch oder nach einem vorgebbaren Ablauf den jeweils anliegenden Steuerwert mehrfach zu digitalisieren und den Speicher 60 zum Speichern des jeweils letzten Wertes oder eines aus einer Vielzahl von Messungen abgeleiteten Wertes zu veranlassen.

Das Sample-and-Hold-Glied 61 und der Analog/Digital-Umsetzer 66 sind über Signalleitungen mit der Steuereinheit 100 verbunden, welche den Zeitpunkt einer jeweiligen Messung des Steuerwertes am Steuereingang des regelbaren Oszillators 40 durch Ausgabe von entsprechenden Signalen an das Sampieand-Hold-Glied 61 bzw. dem Analog/Digital-Umsetzer 66 vorgeben kann.

Sowohl das Sample-and-Hold-Glied 61 als auch der Analog/Digital-Umsetzer 66 können zur Minderung der kapazitiven Last am Steuereingang des regelbaren Oszillators 40 oder zur Bestimmung des Zeitpunkts der Messung des Steuersignals durch jeweils einen weiteren Schalter ab- und zuschaltbar sein.

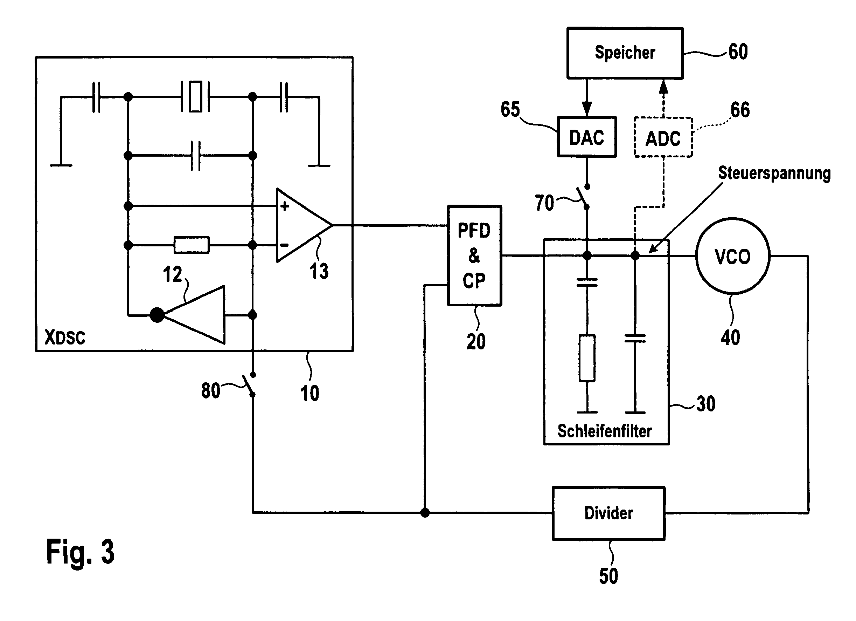

Figur 3 zeigt eine etwas konkretere und erweiterte Darstellung des erfindungsgemäßen Phasenregelkreises gemäß Figur 1. Der Referenzoszillator 10 ist als Quarzoszillator ausgeführt, der gemäß der in der Abbildung dargestellten Schaltung mit einem Schwingquarz, drei Kapazitäten (z.B. Kondensatoren), einem Widerstand, einem invertierenden Verstärker 12 und einem Differenzverstärker 13 ausgeführt sein kann. Der regelbare Oszillator 40 der abgebildeten Ausführungsvariante ist als spannungsgesteuerter Oszillator (VCO) ausgeführt, so dass das Steuersignal bzw. die vom Speicher gespeicherten Steuerwerte für den regelbaren Oszillator 40 elektrische Spannungen sind bzw. repräsentieren. Das Schleifenfilter 30 des erfindungsgemäßen Phasenregelkreises kann als Schaltung aus zwei Kapazitäten und einem Widerstand mit einem Pol und einer Nullstelle ausgeführt sein, wie in der Abbildung angegeben. Der erfindungsgemäße Phasenregelkreis kann optional um einen Analog/Digital-Umsetzer 66 erweitert werden, der in Figur 3 gestrichelt dargestellt ist.

## Patentansprüche

1. Phasenregelkreis zur Verkürzung der Anlaufzeit eines Referenzoszillators (10) mit
- einem Phasen- oder Phasenfrequenzdetektor (20),
- einem regelbaren Oszillator (40),
- einem Schleifenfilter (30) und
- einem Frequenzteiler (50),
wobei der Phasenregelkreis den Referenzoszillator (10) umfasst oder mit dem Referenzoszillator (10) verbindbar ist und der Referenzoszillator (10) ausgebildet ist, ein Referenztaktsignal zu erzeugen und an einen Referenzeingang des Phasen- oder Phasenfrequenzdetektors (20) auszugeben,
wobei der regelbare Oszillator (40) einen Steuereingang für ein Steuersignal besitzt und ausgebildet ist, ein Taktsignal mit einer durch das im Betrieb am Steuereingang anliegende Steuersignal einstellbaren Synthesefrequenz zu erzeugen und an den Frequenzteiler (50) auszugeben,
wobei der Frequenzteiler (50) ausgebildet ist, das vom regelbaren Oszillator (40) ausgegebene Taktsignal durch einen Teilerwert zu teilen und so ein Teilertaktsignal zu erzeugen, das eine gegenüber der Synthesefrequenz um den Teilerwert heruntergesetzte Frequenz aufweist, und das Teilertaktsignal an einen Rückkoppeleingang des Phasen- oder Phasenfrequenzdetektor (20) auszugeben,
wobei der Phasen- oder Phasenfrequenzdetektor (20) ausgebildet ist, das Referenztaktsignal und das Teilertaktsignal miteinander zu vergleichen und ein Vergleichssignal zu erzeugen, das eine Information über den Phasenbezug oder den Frequenzbezug oder über den Phasenbezug und den Frequenzbezug von Referenz- und Teilertaktsignal enthält, und das Vergleichssignal an das Schleifenfilter (30) auszugeben,
wobei das Schleifenfilter (30) ausgebildet ist, durch Filtern des vom Phasen- oder Phasenfrequenzdetektor (20) ausgegebenen Vergleichssignals ein Steuersignal zu erzeugen und an den regelbaren Oszillator (40) auszugeben,
wobei der Phasenregelkreis über einen Speicher (60, 61) für einen Steuerwert verfügt, der über einen abhängig von einem ersten Schaltsignal schaltbaren ersten Schalter (70) mit dem Steuereingang des regelbaren Oszillators (40) verbindbar und ausgebildet ist, einen gespeicherten Steuerwert auszugeben, und
wobei der Frequenzteiler (50) ausgangsseitig über einen abhängig von einem zweiten Schaltsignal schaltbaren zweiten Schalter (80) mit dem Referenzoszillator (10) verbindbar ist,
**dadurch gekennzeichnet,**
**dass** der Referenzoszillator ausgebildet ist, durch Stimulation mit einer nahe der Resonanzfrequenz des Referenzoszillators (10) liegenden Frequenz die Anlaufzeit des Referenzoszillators (10) zu verkürzen.

2. Phasenregelkreis nach Anspruch 1, bei dem dem Referenzoszillator (10) ein Referenztaktteiler (14) nachgeschaltet ist, der ausgebildet ist, das Referenztaktsignal durch Teilen durch einen Referenzteilerwert zu erzeugen und an den Phasen- oder Phasenfrequenzdetektor (20) auszugeben.

3. Phasenregelkreis nach einem der Ansprüche 1 oder 2, **dadurch gekennzeichnet, dass** der Speicher (60, 61) ausgebildet ist, einen digitalen Steuerwert zu speichern und auszugeben, und dass der Phasenregelkreis über einen Digital/Analog-Umsetzer (65) verfügt, der eingangsseitig mit dem Speicher (60, 61) und ausgangsseitig mit dem Steuereingang des regelbaren Oszillators (40) verbunden und ausgebildet ist, einen vom Speicher (60, 61) ausgegebenen digitalen Steuerwert in einen analogen Steuerwert für den regelbaren Oszillator (40) umzusetzen.

4. Phasenregelkreis nach Anspruch 3, **dadurch gekennzeichnet, dass** der Phasenregelkreis über einen Analog/Digital-Umsetzer (66) verfügt, der eingangsseitig mit dem Steuereingang des regelbaren Oszillators (40) verbunden oder verbindbar ist und der ausgangsseitig mit dem Speicher (60, 61) verbunden und ausgebildet ist, einen am Steuereingang des regelbaren Oszillators (40) anliegenden Steuerwert in einen digitalen Steuerwert umzusetzen und an den Speicher (60, 61) auszugeben.

5. Phasenregelkreis nach einem der Ansprüche 1 oder 2, **dadurch gekennzeichnet, dass** der Speicher (60, 61) als Sample-and-Hold-Glied (61) ausgebildet ist, einen am Steuereingang des regelbaren Oszillators anliegenden Steuerwert abzutasten, zu speichern und an den Steuereingang des regelbaren Oszillators (40) auszugeben.

6. Phasenregelkreis nach einem der Ansprüche 3 oder 4 und nach Anspruch 5, **dadurch gekennzeichnet, dass** der Phasenregelkreis zwei Speicher (60, 61) aufweist, von denen ein erster Speicher (60) als Speicher für einen digitalen Steuerwert und ein zweiter Speicher (61) als Sample-and-Hold-Glied ausgebildet sind.

7. Phasenregelkreis nach einem der vorhergehenden Ansprüche, **gekennzeichnet durch** einen abhängig von einem dritten Schaltsignal schaltbaren dritten Schalter (90), der derart zwischen Phasen- oder Phasenfrequenzdetektor (20) und regelbaren Oszillator (40) geschaltet ist, dass der Steuereingang des regelbaren Oszillators (40) vom Ausgang des Phasen- oder Phasenfrequenzdetektors (20) abtrennbar ist.

8. Phasenregelkreis nach einem der vorhergehenden Ansprüche, **gekennzeichnet durch** eine Steuereinheit (100), die ausgebildet ist, auf ein Initialisierungssignal hin ein erstes und ein zweites Schaltsignal auszugeben, die den ersten bzw. zweiten Schalter (70 bzw. 80) dazu veranlassen, sich zu schließen.

9. Phasenregelkreis nach den Ansprüchen 7 und 8, **dadurch gekennzeichnet, dass** die Steuereinheit (100) ausgebildet ist, auf das Initialisierungssignal hin ein drittes Schaltsignal auszugeben, dass den dritten Schalter (90) dazu veranlasst, sich zu öffnen.

10. Phasenregelkreis nach Anspruch 8, **gekennzeichnet durch** einen Referenztaktdetektor (110), der mit dem Referenzoszillator (10) verbunden und ausgebildet ist, das Vorhandensein eines gültigen Referenztaktsignals zu detektieren und der Steuereinheit (100) **durch** ein PLL-Startsignal zu signalisieren.

11. Phasenregelkreis nach Anspruch 10, **dadurch gekennzeichnet, dass** die Steuereinheit (100) ausgebildet ist, auf den Erhalt des PLL-Startsignals hin ein erstes und ein zweites Schaltsignal auszugeben, die den ersten bzw. zweiten Schalter (70 bzw. 80) veranlassen, sich zu öffnen.

12. Phasenregelkreis nach den Ansprüchen 9 und 11, **dadurch gekennzeichnet, dass** die Steuereinheit (100) ausgebildet ist, auf den Erhalt des PLL-Startsignals hin ein drittes Schaltsignal auszugeben, das den dritten Schalter (90) veranlasst, sich zu schließen.

13. Phasenregelkreis nach einem der vorhergehenden Ansprüche, **dadurch gekennzeichnet, dass** der Speicher (60, 61) ausgebildet ist, eine Reihe von verschiedenen Steuerwerten auszugeben.

14. Elektromedizinisches Implantat, insbesondere ein Herzschrittmacher, Defibrillator oder Kardioverter, mit einer Telemetrieeinheit für die Übertragung von Daten vom Implantat an ein externes Gerät, **dadurch gekennzeichnet, dass** die Telemetrieeinheit für die Erzeugung eines Sende- oder Empfangstaktes einen Phasenregelkreis gemäß einem der vorhergehenden Ansprüche umfasst.

## Claims

1. A phase-locked loop for shortening the rise time of a reference oscillator (10) with
- a phase detector or phase frequency detector (20),
- a controllable oscillator (40),
- a loop filter (30) and
- a frequency divider (50),
wherein the phase-locked loop comprises the reference oscillator (10) or can be connected to the reference oscillator (10) and the reference oscillator (10) is designed to generate a reference pulse signal and to output it to a reference input of the phase detector or phase frequency detector (20),
wherein the controllable oscillator (40) has a control input for a control signal and is designed to generate a pulse signal with a synthesis frequency that is adjustable by the control signal applied to the control input during operation and to output it to the frequency divider (50),
wherein the frequency provider (50) is designed to divide the pulse signal output by the controllable oscillator (40) by a divider value and thereby generate a divider pulse signal that has a frequency that is stepped down by the divider value in comparison with the synthesis frequency and to output the divider pulse signal to a feedback input of the phase detector or phase frequency detector (20),
wherein the phase detector or phase frequency detector (20) is designed to compare the reference pulse signal and the divider pulse signal with one another and to generate a comparison signal containing information about the phase reference or the frequency reference or about the phase reference and the frequency reference of the reference pulse signal and the divider pulse signal and to output the comparison signal to the loop filter (30),
wherein the loop filter (30) is designed to generate a control signal by filtering the comparison signal output by the phase detector or phase frequency detector (20) and to output it to the controllable oscillator (40),
wherein the phase-locked loop has a memory (60, 61) for a control value which can be connected to the control input of the controllable oscillator (40) via a first switch (70) that is switchable as a function of a first switch signal and is designed to output a stored control value, and
wherein the frequency divider (50) can be connected at the output to the reference oscillator (10) via a second switch (80) that is switchable as a function of a second switch signal,
**characterized in that**
the reference oscillator is designed to shorten the rise time of the reference oscillator (10) by stimulation with a frequency close to the resonant frequency of the reference oscillator (10).

2. The phase-locked loop according to Claim 1, wherein a reference pulse divider (14) is connected downstream from the reference oscillator (10) and is designed to generate the reference pulse signal by dividing by a reference divider value and outputting it to the phase detector or phase frequency detector (20).

3. The phase-locked loop according to any one of Claims 1 or 2, **characterized in that** the memory (60, 61) is designed to store and output a digital control value, and the phase-locked loop has a digital/analog converter (65), which is connected at the input to the memory (60, 61) and at the output to the control input of the controllable oscillator (40) and is designed to convert a digital control value output by the memory (60, 61) into an analog control value for the controllable oscillator (40).

4. The phase-locked loop according to Claim 3, **characterized in that** the phase-locked loop has an analog/digital converter (66), which is or can be connected at the input to the control input of the controllable oscillator (40) and is connected at the output to the memory (60, 61) and is designed to convert a control value applied to the control input of the controllable oscillator (40) into a digital control value and output it to the memory (60, 61).

5. The phase-locked loop according to any one of Claims 1 or 2, **characterized in that** the memory (60, 61) is designed as a sample-and-hold element (61) to sample a control value applied to the control input of the controllable oscillator, to store it and to output it to the control input of the controllable oscillator (40).

6. The phase-locked loop according to any one of Claims 3 or 4 and according to Claim 5, **characterized in that** the phase-locked loop has two memories (60, 61), of which a first memory (60) is designed as a memory for a digital control value and a second memory (61) is designed as a sample-and-hold element.

7. The phase-locked loop according to any one of the preceding claims, **characterized by** a third switch (90) which is switchable as a function of a third switch signal and is switched between the phase detector or phase frequency detector (20) and the controllable oscillator (40) in such a way that the control input of the controllable oscillator (40) can be separated from the output of the phase detector or phase frequency detector (20).

8. The phase-locked loop according to any one of the preceding claims, **characterized by** a control unit (100) designed to output a first and a second switch signal, causing the first and/or second switches (70 and/or 80) to close, in response to an initialization signal.

9. The phase-locked loop according to any one of Claims 7 and 8, **characterized in that** the control unit (100) is designed to output a third switch signal in response to the initialization signal, the third switch signal causing the third switch (90) to open.

10. The phase-locked loop according to Claim 8, **characterized by** a reference pulse detector (110) which is connected to the reference oscillator (10) and is designed to detect the presence of a valid reference pulse signal and to signal it to the control unit (100) by a PLL start signal.

11. The phase-locked loop according to Claim 10, **characterized in that** the control unit (100) is designed to output a first and a second switch signal in response to the receipt of the PLL start signal, causing the first and/or second switches (70 and/or 80) to open.

12. The phase-locked loop according to Claims 9 and 11, **characterized in that** the control unit (100) is designed to output a third switch signal in response to receipt of the PLL start signal, causing the third switch (90) to close.

13. The phase-locked loop according to any one of the preceding claims, **characterized in that** the memory (60, 61) is designed to output a series of different control values.

14. An electromedical implant, in particular a cardiac pacemaker, defibrillator or cardioverter, which a telemetry unit for transmission of data from the implant to an external device, **characterized in that** the telemetry unit comprises a phase-locked loop according to any one of the preceding claims for generating a transmission or reception pulse.

## Revendications

1. Circuit régulateur de phase destiné à réduire le temps de démarrage d'un oscillateur de fréquence (10) comprenant
- un détecteur de phase ou un détecteur de fréquence de phase (20),
- un oscillateur (40) réglable,
- un filtre à boucle (30) et
- un diviseur de fréquence (50),
le circuit régulateur de phase comportant l'oscillateur de référence (10) ou pouvant être relié à l'oscillateur de référence (10) et l'oscillateur de référence (10) étant conçu pour générer un signal de synchronisation de référence et le livrer à une entrée de référence du détecteur de phase ou du détecteur de fréquence de phase (20), l'oscillateur (40) réglable présentant une entrée de commande pour un signal de commande et étant conçu pour générer un signal de synchronisation avec une fréquence de synthèse pouvant être réglée par le signal de commande s'appliquant pendant le service sur l'entrée de commande et pour le livrer au diviseur de fréquence (50),
le diviseur de fréquence (50) étant conçu pour diviser le signal de synchronisation fourni par l'oscillateur (40) réglable par une valeur de diviseur et générer un signal de synchronisation de diviseur, qui présente une fréquence abaissée de la valeur de diviseur par rapport à la fréquence de synthèse, et livrer le signal de synchronisation de diviseur à une entrée de rétroaction du détecteur de phase ou du détecteur de fréquence de phase (20),
le détecteur de phase ou détecteur de fréquence de phase (20) étant conçu pour comparer le signal de synchronisation de référence et le signal de synchronisation de diviseur l'un avec l'autre et pour générer un signal de comparaison qui contient l'information sur le rapport de phases ou le rapport de fréquence ou sur le rapport de phase et le rapport de fréquence du signal de synchronisation de référence et du signal de synchronisation de diviseur, et envoyer le signal de comparaison au filtre à boucle (30), le filtre à boucle (30) étant conçu pour générer un signal de commande par filtrage du signal de comparaison délivré par le détecteur de phase ou le détecteur de fréquence de phase (20) et l'envoyer à l'oscillateur (40) réglable,
le circuit régulateur de phase disposant d'une mémoire (60, 61), qui peut être reliée par un premier commutateur (70) commutable en fonction d'un premier signal de commutation à l'entrée de commande de l'oscillateur (40) réglable et conçu pour envoyer une valeur de commande mémorisée, et
le diviseur de fréquence (50) pouvant être relié côté sortie par un second commutateur (80) commutant en fonction d'un second signal de commutation à l'oscillateur de référence (10),
**caractérisé en ce que**
l'oscillateur de fréquence est conçu pour raccourcir le temps de démarrage de l'oscillateur de référence (10) par stimulation avec une fréquence située à proximité de la fréquence de résonance de l'oscillateur de référence (10).

2. Circuit régulateur de phase selon la revendication 1, dans lequel un diviseur de synchronisation de référence (14) est placé en aval de l'oscillateur de référence (10), lequel diviseur est conçu pour générer le signal de synchronisation de référence par division par une valeur de diviseur de référence et le livrer au détecteur de phase ou de fréquence de phase (20).

3. Circuit régulateur de phase selon l'une quelconque des revendications 1 ou 2, **caractérisé en ce que** la mémoire (60, 61) est conçue pour stocker et délivrer une valeur de commande numérique, et **en ce que** le circuit régulateur de phase dispose d'un convertisseur numérique/analogique (65), qui est relié côté entrée à la mémoire (60, 61) et côté sortie à l'entrée de commande de l'oscillateur (40) réglable et est conçu pour convertir une valeur de commande numérique délivrée par la mémoire (60, 61) en une valeur de commande analogique pour l'oscillateur (40) réglable.

4. Circuit régulateur de phase selon la revendication 3, **caractérisé en ce que** le circuit régulateur de phase dispose d'un convertisseur analogique/numérique (66), qui est relié ou peut être relié côté entrée à l'entrée de commande de l'oscillateur (40) réglable et qui est relié côté sortie à la mémoire (60, 61) et est conçu pour convertir une valeur de commande s'appliquant sur l'entrée de commande de l'oscillateur (40) réglable en une valeur de commande numérique et la livrer à la mémoire (60, 61).

5. Circuit régulateur de phase selon l'une quelconque des revendications 1 ou 2, **caractérisé en ce que** la mémoire (60, 61) est conçue sous la forme d'un élément Sample-and-Hold (61) pour balayer une valeur de commande s'appliquant sur l'entrée de commande de l'oscillateur réglable, la mémoriser et la livrer à l'entrée de commande de l'oscillateur (40) réglable.

6. Circuit régulateur de phase selon l'une quelconque des revendications 3 ou 4 et selon la revendication 5, **caractérisé en ce que** le circuit régulateur de phase présente deux mémoires (60, 61), dont une première mémoire (60) est conçue comme mémoire pour une valeur de commande numérique et une seconde mémoire (61) comme élément Sample-and-Hold.

7. Circuit régulateur de phase selon l'une quelconque des revendications précédentes, **caractérisé par** un troisième commutateur (90) pouvant être commuté en fonction d'un troisième signal de commutation, qui est commuté entre le détecteur de phase ou de fréquence de phase (20) et l'oscillateur (40) réglable de telle sorte que l'entrée de commande de l'oscillateur (40) réglable peut être déconnectée de la sortie du détecteur de phase ou de fréquence de phase (20).

8. Circuit régulateur de phase selon l'une quelconque des revendications précédentes, **caractérisé par** une unité de commande (100), qui est conçue pour délivrer à la suite d'un signal d'initialisation un premier et un second signal de commutation, qui ordonnent au premier ou au second commutateur (70 ou 80) de se fermer.

9. Circuit régulateur de phase selon les revendications 7 et 8, **caractérisé en ce que** l'unité de commande (100) est conçue pour délivrer à la suite d'un signal d'initialisation un troisième signal de commutation qui ordonne au troisième interrupteur (90) de s'ouvrir.

10. Circuit régulateur de phase selon la revendication 8, **caractérisé par** un détecteur de synchronisation de référence (110), qui est relié à un oscillateur de référence (10) et est conçu pour détecter la présence d'un signal de synchronisation de référence valable et le signaler à l'unité de commande (100) un signal de démarrage PLL.

11. Circuit régulateur de phase selon la revendication 10, **caractérisé en ce que** l'unité de commande (100) est conçue pour délivrer à la suite de la réception du signal de démarrage PLL un premier et un second signal de commutation qui ordonnent au premier ou au second interrupteur (70 ou 80) de s'ouvrir.

12. Circuit régulateur de phase selon les revendications 9 et 11, **caractérisé en ce que** l'unité de commande (100) est conçue pour délivrer à la suite de la réception du signal de démarrage PLL un troisième signal de commutation qui ordonne au troisième interrupteur (90) de se fermer.

13. Circuit régulateur de phase selon l'une quelconque des revendications précédentes**, caractérisé en ce que** la mémoire (60, 61) est conçue pour délivrer une série de valeurs de commande différentes.

14. Implant électromédicinal, en particulier un pacemaker, défibrillateur ou cardioverteur, comprenant une unité de télémétrie pour la transmission de données de l'implant à un appareil extérieur, **caractérisé en ce que** l'unité de télémétrie comprend un circuit régulateur de phase selon l'une quelconque des revendications précédentes pour la génération d'une cadence d'émission ou de réception.
